# DEMANDE DE BREVET EUROPEEN

(11) **EP 0 898 367 A1**
(43) Date de publication de la demande: **24.02.1999**
(21) Numéro de dépôt: 98402087.5
(22) Date de dépôt: 20.08.1998
(51) Int. Cl.: H03K 17/725, H01H 9/54

(54) **Montage va-et-vient électronique**

(30) Priorité: 22.08.1997 FR 9710575
(71) Demandeur: LEGRAND, F-87000 Limoges (FR); LEGRAND SNC, F-87000 Limoges (FR)
(72) Inventeur: Cousy, Jean-Pierre, 87430 Verneuil Sur Vienne (FR)
(74) Mandataire: CABINET BONNET-THIRION

(57) **Abrégé**

Suivant l'invention, ce montage va-et-vient comporte deux interrupteurs électroniques (10) disposés tête-bêche, chacun de ces interrupteurs électroniques (10) comportant, en parallèle, deux organes de coupure électroniques (13, 13') dont les circuits de commande (14, 14') ont en commun un organe d'actionnement (17) apte à fermer alternativement l'un ou l'autre d'entre eux.

## Description

La présente invention concerne d'une manière générale les montages va-et-vient du type de ceux mis en oeuvre pour la commande alternée d'une quelconque charge à partir de l'un ou de l'autre de deux postes de commande distincts éventuellement distants l'un de l'autre.

Ces montages va-et-vient sont à ce jour exclusivement formés d'interrupteurs mécaniques, avec les inconvénients inhérents à ceux-ci, notamment en ce qui concerne la création d'arcs susceptibles de conduire à une détérioration importante des contacts électriques concernés et la génération de bruits.

La présente invention est fondée sur l'observation, non formulée à ce jour, qu'il est possible de réaliser de tels montages va-et-vient avec des interrupteurs électroniques.

Elle a donc pour objet un montage va-et-vient caractérisé en ce qu'il comporte deux interrupteurs électroniques disposés tête-bêche, chacun de ces interrupteurs électroniques comportant, en parallèle, deux organes de coupure électroniques dont les circuits de commande ont en commun un organe d'actionnement apte à fermer alternativement l'un ou l'autre d'entre eux.

De fonctionnement par lui-même non générateur d'arc et silencieux, ce montage va-et-vient est avantageusement susceptible d'être commandé par des interrupteurs tactiles, en bénéficiant ainsi également des avantages de faible course et de faible bruit de ceux-ci.

Il est en outre avantageusement possible de l'installer si désiré en lieu et place d'un interrupteur mécanique déjà installé, sans utilisation du neutre.

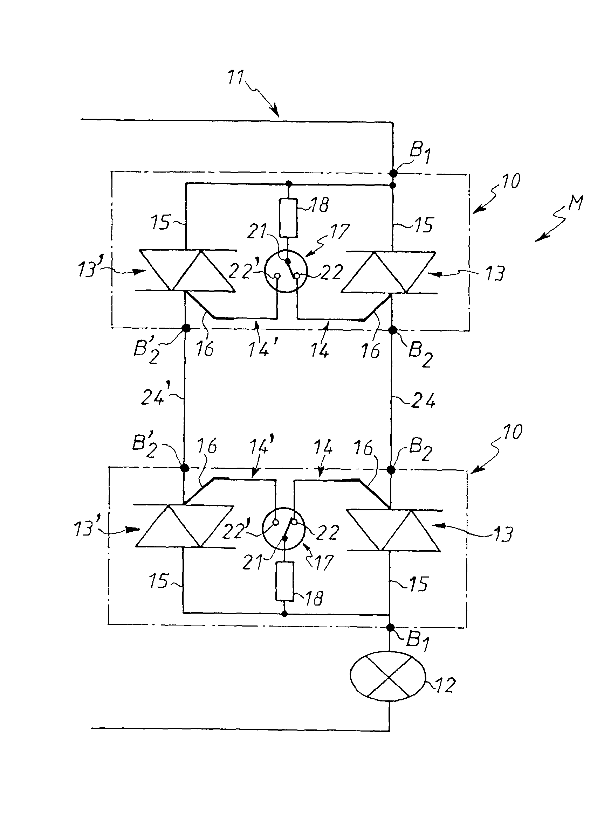

Les caractéristiques et avantages de l'invention ressortiront d'ailleurs de la description qui va suivre, à titre d'exemple, en référence au dessin annexé dont la figure unique est un schéma de principe d'un montage va-et-vient suivant l'invention.

Tel qu'illustré sur cette figure, le montage va-et-vient M suivant l'invention comporte, entre deux bornes d'entrée B1 par lesquelles il est apte à être inséré sur un circuit de puissance 11 desservant la charge 12 à commander, deux interrupteurs électroniques 10 disposés tête-bêche.

Préférentiellement, et cela est le cas dans la forme de réalisation représentée, ces interrupteurs électroniques 10 sont identiques entre eux.

Chacun d'eux comporte, en parallèle, entre la borne d'entrée B1 correspondante et deux bornes de sortie B2, B'2, deux organes de coupure électroniques 13, 13' dont les circuits de commande 14, 14' ont en commun un organe d'actionnement 17 apte à fermer alternativement l'un ou l'autre d'entre eux.

Dans la forme de réalisation représentée, les organes de coupure électroniques 13, 13' sont, pour chacun des interrupteurs électroniques 10, des triacs, et leurs circuits de commande 14, 14' s'étendent de leur anode 15 à leur gâchette 16.

L'anode 15 se situe du côté de la borne d'entrée B1, et la gâchette 16 du côté de la borne de sortie B2, B'2 correspondante.

Préférentiellement, et cela est le cas dans la forme de réalisation représentée, les circuits de commande 14, 14' des deux organes de coupure électroniques 13, 13' de chacun des interrupteurs électroniques 10 ont en commun une résistance de limitation de courant 18, entre l'organe d'actionnement 17 et la borne d'entrée B1.

Dans la forme de réalisation représentée, l'organe d'actionnement 17 est, pour chacun des interrupteurs électroniques 10, un inverseur.

Par sa borne centrale 21, cet organe d'actionnement 17 est relié, par l'intermédiaire de la résistance de limitation de courant 18, à l'anode 15 de chacun des deux organes de coupure électroniques 13, 13', tandis que, par ses bornes latérales 22, 22', il est relié à la gâchette 16 de ceux-ci.

Enfin, les interrupteurs électroniques 10 sont reliés l'un à l'autre par les gâchettes 16 de leurs organes de coupure électroniques 13, 13'.

Plus précisément, la gâchette 16 de chacun des deux organes de coupure électroniques 13, 13' de l'un des interrupteurs électroniques 10, et, donc, la borne de sortie B2, B'2 concernée de celui-ci, est reliée à la gâchette 16 de l'organe de coupure électronique 13, 13' correspondant de l'autre des interrupteurs électroniques 10, et, donc, à la borne de sortie B2, B'2 correspondante de ce dernier.

Par exemple, et tel que représenté, les liaisons correspondantes se font à l'aide de simples fils conducteurs navettes 24, 24', qui appartiennent en pratique à l'installation électrique concernée.

Pour chacun des interrupteurs électroniques 10, les organes de coupure électroniques 13, 13' sont alternativement passants et bloqués.

L'ensemble est passant lorsqu'un même organe de coupure électronique 13 ou 13' est passant dans l'un et l'autre des deux interrupteurs électroniques 10, et il est bloqué dans le cas contraire.

Dans l'un et l'autre cas, il est possible de changer l'état de l'ensemble, et, donc, d'assurer, ou non, l'alimentation de la charge 12, en intervenant sur l'un ou l'autre des organes d'actionnement 17.

Cette intervention peut se faire directement, ou indirectement, par l'intermédiaire d'un quelconque autre moyen de commande à la disposition de l'usager.

Quoi qu'il en soit, à chaque intervention sur un organe d'actionnement 17, les organes de coupure électroniques 13, 13' de l'interrupteur électronique 10 correspondant changent l'un et l'autre d'état.

Par exemple, dans la configuration représentée sur la figure, pour chacun des interrupteurs électroniques 10, l'organe de coupure électronique 13 est passant tandis que l'organe de coupure électronique 13' est bloqué, et la charge 12 est alimentée.

Si, à partir d'une telle configuration, il est agi sur l'organe d'actionnement 17 de l'un ou l'autre des interrupteurs électroniques 10, l'organe de coupure électronique 13 de cet interrupteur électronique 10 devient bloqué, ce qui coupe l'alimentation de la charge 12.

Ainsi, si, ensuite, il est agi sur l'organe d'actionnement 17 de l'autre interrupteur électronique 10, les organes de coupure électroniques 13' de chacun des deux interrupteurs électroniques 10 deviennent simultanément passants, ce qui assure à nouveau l'alimentation de la charge 12, cependant que l'organe de coupure électronique 13 de cet autre interrupteur électronique 10 est à son tour bloqué.

A partir de la nouvelle configuration de l'ensemble, qui est inverse de la précédente, un processus identique à celui précédemment décrit se développe s'il est agi sur l'organe d'actionnement 17 de l'un ou l'autre des interrupteurs électroniques 10.

Préférentiellement, pour chacun des interrupteurs électroniques 10, les organes de coupure électroniques 13, 13' sont identiques entre eux.

Préférentiellement, également, pour chacun des interrupteurs électroniques 10, la valeur de la résistance de limitation de courant 18 est inférieure à la valeur du front de tension à l'amorçage des organes de coupure électroniques 13, 13' divisée par la valeur du courant de gâchette minimal nécessaire à un tel organe de coupure électronique 13, 13' pour un tel amorçage.

Ainsi, les harmoniques parasites générés à l'amorçage demeurent avantageusement admissibles.

Bien entendu, la présente invention ne se limite pas à la forme de réalisation décrite et représentée, mais englobe toute variante d'exécution.

## Revendications

1. Montage va-et-vient, caractérisé en ce qu'il comporte deux interrupteurs électroniques (10) disposés tête-bêche, chacun de ces interrupteurs électroniques (10) comportant, en parallèle, deux organes de coupure électroniques (13, 13') dont les circuits de commande (14, 14') ont en commun un organe d'actionnement (17) apte à fermer alternativement l'un ou l'autre d'entre eux.

2. Montage va-et-vient suivant la revendication 1, caractérisé en ce que, pour chacun des organes de coupure électronique (13, 13') des interrupteurs électroniques (10), le circuit de commande (14, 14') s'étend de l'anode (15) à la gâchette (16).

3. Montage va-et-vient suivant l'une quelconque des revendications 1, 2, caractérisé en ce que, pour chacun des interrupteurs électroniques (10), les organes de coupure électroniques (13, 13') sont des triacs.

4. Montage va-et-vient suivant l'une quelconque des revendications 1 à 3, caractérisé en ce que, pour chacun des interrupteurs électroniques (10), les circuits de commande (14, 14') ont en commun une résistance de limitation de courant (18).

5. Montage va-et-vient suivant l'une quelconque des revendications 1 à 4, caractérisé en ce que, pour chacun des interrupteurs électroniques (10), l'organe d'actionnement (17) est un inverseur.

6. Montage va-et-vient suivant la revendication 5, caractérisé en ce que, pour chacun des interrupteurs électroniques (10), l'organe d'actionnement (17) est relié, par sa borne centrale (21), à l'anode (15) de chacun des deux organes de coupure électroniques (13, 13'), et, par ses bornes latérales (22, 22'), à la gâchette (16) de ceux-ci.

7. Montage va-et-vient suivant l'une quelconque des revendications 1 à 6, caractérisé en ce que les deux interrupteurs électroniques (10) sont identiques entre eux.

8. Montage va-et-vient suivant l'une quelconque des revendications 1 à 7, caractérisé en ce que les interrupteurs électroniques (10) sont reliés l'un à l'autre par les gâchettes (16) de leurs organes de coupure électroniques (13, 13').

9. Montage va-et-vient suivant la revendication 8, caractérisé en ce que la gâchette (16) de chacun des deux organes de coupure électroniques (13, 13') de l'un des interrupteurs électroniques (10) est reliée à la gâchette (16) de l'organe de coupure électronique (13, 13') correspondant de l'autre des interrupteurs électroniques (10).
